# EUROPEAN PATENT APPLICATION

(11) **EP 1 551 064 A2**
(43) Date of publication of application: **06.07.2005**
(21) Application number: 04293146.9
(22) Date of filing: 28.12.2004
(51) Int. Cl.: H01L 33/00

(54) **Light emitting device and manufacturing method thereof.**

(30) Priority: 31.12.2003 KR 2003102255
(71) Applicant: LG ELECTRONICS INC., Seoul (KR)
(72) Inventor: Kim, Geun-Ho, Nokkyung Village B-102, Seoul (KR); Song, Ki-Chang, Samik Apt. 1-1110, Anyang, Gyeonggi-Do (KR)
(74) Representative: Loisel, Bertrand

(57) **Abstract**

Disclosed are a light emitting device and a manufacturing method thereof. A trench portion is formed on a substrate of a light emitting device, and a buffer layer, an n-contact layer, and an active layer are sequentially deposited on the trench portion thereby to increase a light emitting area of the active layer. According to this, a light emitting efficiency is increased, and light of a high brightness can be obtained with a substrate of the same size thereby to reduce a production cost.

## Description

### BACKGROUND OF THE INVENTION

### 1. Field of the Invention

The present invention relates to a light emitting device and a manufacturing method thereof, and more particularly, to a light emitting device capable of enhancing a light emitting efficiency by increasing a light emitting area of an active layer deposited on an upper surface of a substrate and a manufacturing method thereof.

### 2. Description of the Conventional Art

A light emitting device currently being widely used can be largely divided into a laser diode (LD) and a light emitting diode (LED).

The LD is being widely used as an optical source in an optical communication field. Recently, the LD is being used in an optical media field such as not only a compact disc (CD) reproducing apparatus and a compact disc recording-reproducing apparatus (CD-RW) but also a DVD reproducing apparatus, a laser disc (LD) reproducing apparatus, a minimum disc (MD) reproducing apparatus, etc.

The LED is used as a general display device, and is also used as a backlight source of a lighting device or an LCD display device.

The LED can be driven with a comparatively low voltage. Also, the LED has a low heating value due to a high energy efficiency and has a long lifespan. According to this, technique concerning about the LED is being anticipated as a major technique to substitute most of lighting devices currently being used such as a fluorescent lamp, an incandescent lamp, a traffic light, a light for a car, etc.

A research for using the LED as a backlight source of a display device by arranging as an array is being actively performed. Especially, the LED is anticipated as an optical source of backlight to substitute a cold cathode fluorescent lamp (CCFL) used in a thin film transistor (TFT)-LCD.

Light emitting devices using a group III~V material of a direct transition type compound semiconductor such as an LD or an LED can implement various colors such as green, blue, and ultraviolet rays as a thin film growing technique and a device material are developed. Also, since white ray having a good efficiency can be implemented by using fluorescent materials or by combining colors, the light emitting device can be variously used. In order for the light emitting device to be variously used, a low driving voltage and light of a high brightness are required.

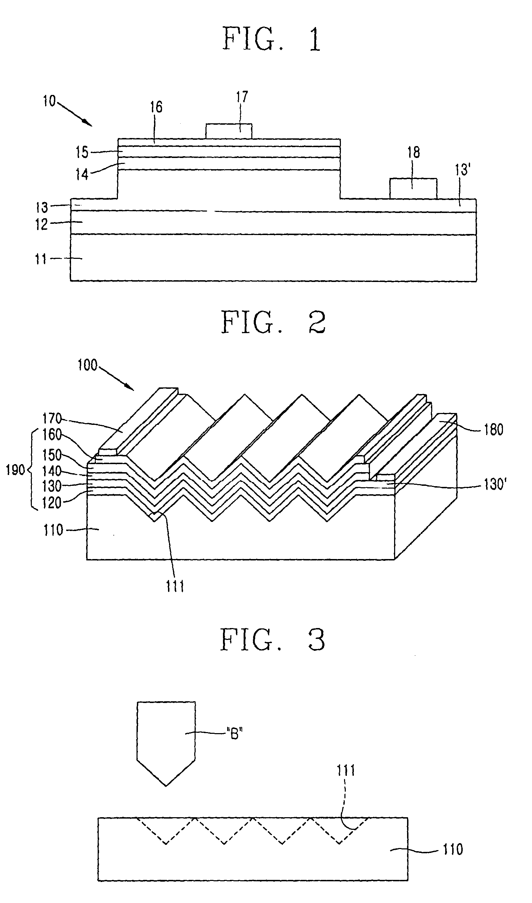

FIG. 1 is a longitudinal section view showing a light emitting device in accordance with the conventional art.

As shown, the conventional light emitting device 10 is formed as a buffer layer 12, an n-contact layer 13, an active layer 14, and a p-contact layer 15 are sequentially deposited on an upper surface of a substrate 11 such as sapphire n-GaAs, etc. by a chemical vapor deposition (CVD) method.

A photosensitive mask (not shown) is patterned on the p-contact layer 15. Then, an exposure and an etching are performed until a part 13' of the n-contact layer 13 is exposed by a photo etching process and a wet etching process (or a dry etching process), and then the photosensitive mask is removed.

Then, a current spreading layer 16 is deposited on the p-contact layer 15, and a p-electrode 17 electrically connected to the p-contact layer 15 and the current spreading layer 16 is formed on the current spreading layer 16. Then, an n-electrode 18 is formed on the exposed part 13' of the n-contact layer 13.

An operation of the conventional light emitting device will be explained as follows.

When a voltage is applied to the p-electrode 17 and the n-electrode 18, holes and electrons are respectively injected into the p-electrode 17 and the n-electrode 18. The injected holes and electrons are introduced into the p-contact layer 15 and the n-contact layer 13, and then, are re-combined in the active layer 14. At this time, redundant energy is converted into light and emitted to outside of the substrate 11.

However, in the conventional light emitting device, since the buffer layer, the n-contact layer, and the active layer are sequentially deposition on the flat upper surface of the substrate, there is a limitation in forming a light emitting area of the active layer that is the most important layer to determine a light emitting efficiency of a light emitting device to be large.

### SUMMARY OF THE INVENTION

Therefore, an object of the present invention is to provide a light emitting device capable of reducing a production cost and capable of enhancing a light emitting efficiency by increasing a light emitting area of an active layer by forming a trench portion on a substrate of the light emitting device and by sequentially depositing a buffer layer, an n-contact layer, and an active layer on the trench portion, and a manufacturing method thereof.

To achieve these and other advantages and in accordance with the purpose of the present invention, as embodied and broadly described herein, there is provided a light emitting device comprising: a substrate having a trench portion on an upper surface thereof; a buffer layer formed on the trench portion of the substrate; an n-contact layer formed on an upper surface of the buffer layer; an active layer formed at one side of an upper surface of the n-contact layer; a p-contact layer formed on an upper surface of the active layer; a current spreading layer formed on an upper surface of the p-contact layer; a p-electrode formed on an upper surface of the current spreading layer so as to be electrically connected to the active layer and the p-contact layer; and an n-electrode formed at another side of the upper surface of the n-contact layer so as to be electrically connected to the n-contact layer.

To achieve these and other advantages and in accordance with the purpose of the present invention, as embodied and broadly described herein, there is also provided a manufacturing method of a light emitting device comprising the steps of: forming a trench portion on an upper surface of a substrate; forming a buffer layer, an n-contact layer, an active layer, a p-contact layer, and a current spreading layer on the upper surface of the substrate where the trench portion is formed; partially removing the active layer, the p-contact layer, and the current spreading layer so that the n-contact layer can be partially exposed; forming a p-electrode on an upper surface of the current spreading layer so as to be electrically connected to the active layer and the p-contact layer; and forming an n-electrode on an upper surface of the exposed n-contact layer so as to be electrically connected to the n-contact layer.

The foregoing and other objects, features, aspects and advantages of the present invention will become more apparent from the following detailed description of the present invention when taken in conjunction with the accompanying drawings.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:
FIG. 1 is a longitudinal section view showing a light emitting device in accordance with the conventional art;
FIG. 2 is a perspective view showing a light emitting device according to first embodiment of the present invention;
FIGs. 3 to 8 are views showing a manufacturing method of the light emitting device according to first embodiment of the present invention;
FIG. 9 is a perspective view showing a light emitting device according to a second embodiment of the present invention; and
FIGs. 10 to 15 are views showing a manufacturing method of the light emitting device according to the second embodiment of the present invention.

### DETAILED DESCRIPTION OF THE PREFERRED EMBODIMENTS

Reference will now be made in detail to the preferred embodiments of the present invention, examples of which are illustrated in the accompanying drawings.

Hereinafter, a light emitting device and a manufacturing method thereof will be explained with reference to the attached drawings as follows.

FIG. 2 is a perspective view showing a light emitting device according to first embodiment of the present invention.

As shown, in a light emitting device 100 according to first embodiment of the present invention, a light emitting area of an active layer 140 is increased by forming a trench portion 111 having a section of a 'V' shape on an upper surface of a substrate 110 by a half cut dicing method and then by forming a semiconductor layer 190 on an upper surface of the trench portion 111, and thereby a light emitting efficiency is enhanced.

The light emitting device 100 according to first embodiment of the present invention comprises: a substrate 110 having a trench portion 111 on an upper surface thereof; a buffer layer 120 formed on the trench portion 111 of the substrate 110; an n-contact layer 130 formed on an upper surface of the buffer layer 120; an active layer 140 formed at one side of an upper surface of the n-contact layer 130; a p-contact layer 150 formed on an upper surface of the active layer 140; a current spreading layer 160 formed on an upper surface of the p-contact layer 150; a p-electrode 170 formed on an upper surface of the current spreading layer 160 so as to be electrically connected to the active layer 140 and the p-contact layer 150; and an n-electrode 180 formed at another side of the upper surface of the n-contact layer 130 so as to be electrically connected to the n-contact layer 130.

The buffer layer 120 and the n-contact layer 130 of the semiconductor layer 190 are formed by a metal organic chemical vapor deposition (MOCVD) method, a molecular beam epitaxy (MBE) method, or a liquid phase epitaxy (LPE) method.

The trench portion 111 can be formed on the entire upper surface of the substrate 110, and can be formed only at a part where a MESA, a light emission region, is formed.

The current spreading layer 160 is formed of a transparent material having a high light transmissivity. According to this, light emitted from the active layer 140 passes through the current spreading layer 160 and is emitted upwardly.

Although not shown, in case that the substrate is formed of a transparent material, the current spreading layer can be formed of a metal electrode of a reflective material. At this time, light emitted from the active layer is emitted towards a lower direction of the substrate.

Preferably, the current spreading layer 160 is formed of Ni/Au or ITO (Indium Tin Oxide).

Preferably, the substrate 110 is formed of sapphire, gallium arsenide, silicon, silicon carbide, or gallium nitride.

Hereinafter, an operation of the light emitting device according to the first embodiment of the present invention will be explained.

When a voltage is applied to the p-electrode 170 and the n-electrode 180, holes and electrons are respectively injected into the p-electrode 170 and the n-electrode 180. The injected holes and electrons are introduced into the p-contact layer 150 and the n-contact layer 130, and then, are re-combined in the active layer 140. At this time, redundant energy is converted into light and passes through the current spreading layer 160, thereby being emitted to an upper side of the substrate 110.

At this time, since a light emitting area of the active layer 140 is more increased than in the conventional light emitting device, light of a high brightness is obtained thereby to enhance a light emitting efficiency and to reduce a production cost.

FIGs. 3 to 8 are views showing a manufacturing method of the light emitting device according to first embodiment of the present invention.

A manufacturing method of a light emitting device according to first embodiment of the present invention comprises the steps of: forming a trench portion 111 at a part of an upper surface of a substrate 110 by a half cut dicing method; forming a buffer layer 120, an n-contact layer 130, an active layer 140, a p-contact layer 150, and a current spreading layer 160 on the upper surface of the substrate 110 where the trench portion 111 is formed; partially removing the active layer 140, the p-contact layer 150, and the current spreading layer 160 so that the n-contact layer 130 can be partially exposed; forming a p-electrode 170 on an upper surface of the current spreading layer 160 so as to be electrically connected to the active layer 140 and the p-contact layer 150; and forming an n-electrode 180 on an upper surface of the exposed n-contact layer so as to be electrically connected to the n-contact layer 150.

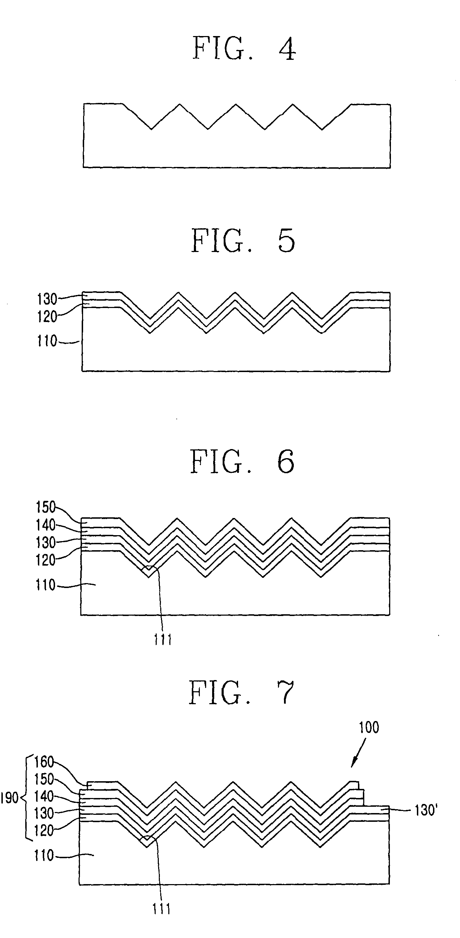

As shown in FIGs. 3 and 4, the trench portion 111 is formed on an upper surface of the substrate 110 by moving a dicing blade B used in a half cut dicing process in a zigzag direction on the upper surface of the substrate 110, a mother substrate. The trench portion 111 can be formed on the entire upper surface of the substrate 110, and can be formed only at a part where a MESA, a light emission region, is formed.

A shape of the trench portion 111 is determined by a shape of the dicing blade B. For example, when the dicing blade has a 'V' shape, the trench portion has a 'V' shape, and when the dicing blade has a 'U' shape, the trench portion has a 'U' shape.

As shown in FIGs. 5 and 6, in the step of forming a semiconductor layer, the buffer layer 120, the n-contact layer 130, the active layer 140, the p-contact layer 150, and the current spreading layer 160 are formed on the entire upper surface of the substrate 110 where the trench portion 111 is formed. At this time, the semiconductor layer 190 is curvedly formed according to the shape of the trench portion 111. Therefore, a light emitting area of the active layer 140 of the semiconductor layer 190 becomes relatively large thereby to enhance a light emitting efficiency.

Preferably, the buffer layer 120 and the n-contact layer 130 are formed by a metal organic chemical vapor deposition (MOCVD) method, a molecular beam epitaxy (MBE) method, or a liquid phase epitaxy (LPE) method.

As shown in FIG. 7, in the mesa patterning step, a photosensitive mask (not shown) is patterned on the p-contact layer 150. Then, an exposure and an etching are performed until a part 130' of the n-contact layer 130 is exposed by a photo etching process and a wet etching process (or a dry etching process), and then the photosensitive mask is removed.

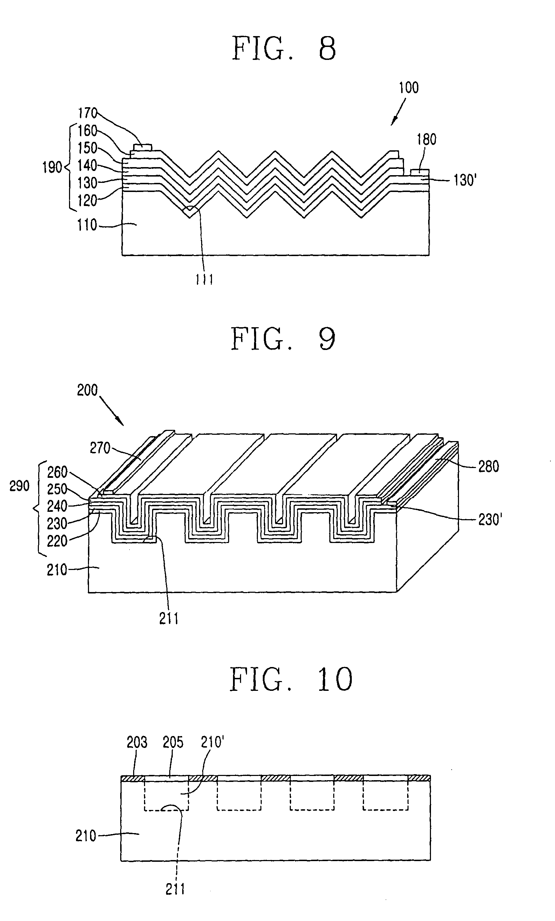

As shown in FIG. 8, in the step of forming the p-electrode and the n-electrode, the p-electrode 170 is formed on an upper surface of the current spreading layer 160 so as to be electrically connected to the active layer 140 and the p-contact layer 150, and the n-electrode 180 is formed on an upper surface of the exposed n-contact layer 130', one part 130' of the n-contact layer 130, thereby completing the light emitting device 100. The p-electrode 170 has the same potential as the current spreading layer 160 and the p-contact layer 150, and the n-electrode 180 has the same potential as the n-contact layer 130.

FIG. 9 is a perspective view showing a light emitting device according to a second embodiment of the present invention.

As shown in FIG. 9, the light emitting device 200 according to the second embodiment of the present invention, a light emitting area of an active layer 240 is increased by forming a trench portion 211 having a section of a 'V' shape on an upper surface of a substrate 210 by an etching process by an etching mask 203 and then by forming a semiconductor layer 290 on an upper surface of the trench portion 211, and thereby a light emitting efficiency is enhanced.

The light emitting device 200 according to the second embodiment of the present invention comprises: a substrate 210 having a trench portion 211 at a part of an upper surface thereof; a buffer layer 220 formed on the trench portion 211 of the substrate 210; an n-contact layer 230 formed on an upper surface of the buffer layer 220; an active layer 240 formed at one side of an upper surface of the n-contact layer 230; a p-contact layer 250 formed on an upper surface of the active layer 240; a current spreading layer 260 formed on an upper surface of the p-contact layer 250; a p-electrode 270 formed on an upper surface of the current spreading layer 260 so as to be electrically connected to the active layer 240 and the p-contact layer 250; and an n-electrode 280 formed at another side of the upper surface of the n-contact layer 230 so as to be electrically connected to the n-contact layer 230.

Hereinafter, an operation of the light emitting device according to the second embodiment of the present invention will be explained.

When a voltage is applied to the p-electrode 270 and the n-electrode 280, holes and electrons are respectively injected into the p-electrode 270 and the n-electrode 280. The injected holes and electrons are introduced into the p-contact layer 250 and the n-contact layer 230, and then, are re-combined in the active layer 240. At this time, redundant energy is converted into light and is emitted to outside of the substrate 210.

At this time, since a light emitting area of the active layer 240 is more increased than in the conventional light emitting device, light of a high brightness is obtained thereby to enhance a light emitting efficiency and to reduce a production cost.

The buffer layer 220 and the n-contact layer 230 of the semiconductor layer 290 are formed by a metal organic chemical vapor deposition (MOCVD) method, a molecular beam epitaxy (MBE) method, or a liquid phase epitaxy (LPE) method.

FIGs. 10 to 15 are views showing a manufacturing method of the light emitting device according to the second embodiment of the present invention.

A manufacturing method of a light emitting device according to the second embodiment of the present invention comprises the steps of: forming a trench portion 211 at a part of an upper surface of a substrate 210 by an etching process using an etching mask 203; forming a buffer layer 210, an n-contact layer 230, an active layer 240, a p-contact layer 250, and a current spreading layer 260 on the upper surface of the substrate 210 where the trench portion 211 is formed; partially removing the active layer 240, the p-contact layer 250, and the current spreading layer 260 so that the n-contact layer 230 can be partially exposed by a mesa patterning processing; forming a p-electrode 270 on an upper surface of the current spreading layer 260 so as to be electrically connected to the active layer 240 and the p-contact layer 250; and forming an n-electrode 280 on an upper surface of the exposed n-contact layer 230 so as to be electrically connected to the n-contact layer 230.

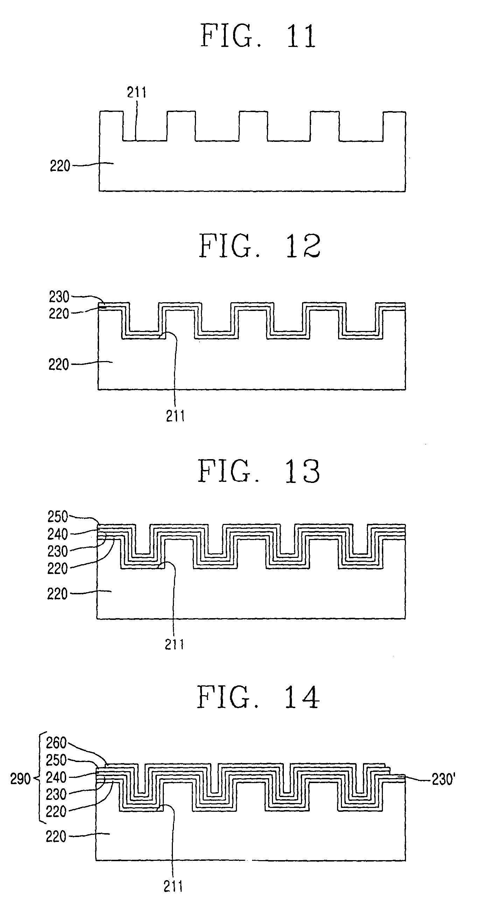

As shown in FIGs. 10 and 11, in the step of forming the trench portion 211, the etching mask 203 is patterned on an upper surface of the substrate 210 by using an etching process, and then a part of the exposed substrate 210 is etched.

The substrate is etched by using an anisotropy dry etching method, a wet etching method, or an isotropic dry etching method.

As shown in FIGs. 12 and 13, in the step of forming a semiconductor layer, the buffer layer 220, the n-contact layer 230, the active layer 240, the p-contact layer 250, and the current spreading layer 260 are formed on the entire upper surface of the substrate 210 where the trench portion 211 is formed. At this time, the semiconductor layer 290 is curvedly formed according to the shape of the trench portion 211. Therefore, a light emitting area of the active layer 240 of the semiconductor layer 290 becomes relatively larger than that of the conventional art thereby to enhance a light emitting efficiency.

Preferably, the buffer layer 220 and the n-contact layer 230 are formed by a metal organic chemical vapor deposition (MOCVD) method, a molecular beam epitaxy (MBE) method, or a liquid phase epitaxy (LPE) method.

As shown in FIG. 14, in the mesa patterning step, a photosensitive mask (not shown) is patterned on the p-contact layer 250. Then, an exposure and an etching are performed until a part 130' of the n-contact layer 230 is exposed by a photo etching process and a wet etching process (or a dry etching process), and then the photosensitive mask is removed.

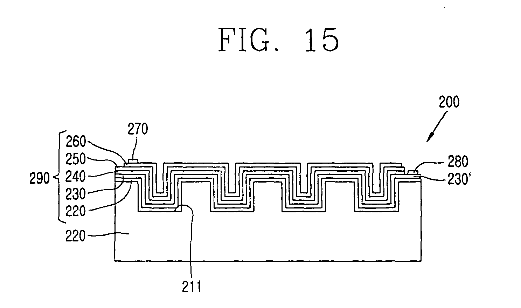

As shown in FIG. 15, in the step of forming the p-electrode and the n-electrode, the p-electrode 270 is formed on an upper surface of the current spreading layer 260 so as to be electrically connected to the active layer 240 and the p-contact layer 250, and the n-electrode 280 is formed on an upper surface of the exposed n-contact layer 230', one part 230' of the n-contact layer 230, thereby completing the light emitting device 200. The p-electrode 270 has the same potential as the current spreading layer 260 and the p-contact layer 250, and the n-electrode 280 has the same potential as the n-contact layer 230.

As aforementioned, in the light emitting device and the manufacturing method thereof according to the present invention, the trench portion is formed on the substrate of the light emitting device, and then, the buffer layer, the n-contact layer, and active layer are sequentially deposited on the trench portion. According to this, a light emitting area of the active layer is increased thus to obtain light of a high brightness, thereby enhancing a light emitting efficiency and reducing a production cost.

As the present invention may be embodied in several forms without departing from the spirit or essential characteristics thereof, it should also be understood that the above-described embodiments are not limited by any of the details of the foregoing description, unless otherwise specified, but rather should be construed broadly within its spirit and scope as defined in the appended claims, and therefore all changes and modifications that fall within the metes and bounds of the claims, or equivalence of such metes and bounds are therefore intended to be embraced by the appended claims.

## Claims

1. A light emitting device comprising:
a substrate having a trench portion on an upper surface thereof;
a buffer layer formed on the trench portion of the substrate;
an n-contact layer formed on an upper surface of the buffer layer;
an active layer formed at one side of an upper surface of the n-contact layer;
a p-contact layer formed on an upper surface of the active layer;
a current spreading layer formed on an upper surface of the p-contact layer;
a p-electrode formed on an upper surface of the current spreading layer so as to be electrically connected to the active layer and the p-contact layer; and
an n-electrode formed at another side of the upper surface of the n-contact layer so as to be electrically connected to the n-contact layer.

2. The device of claim 1, wherein the trench portion is formed at a part of the upper surface of the substrate.

3. The device of claim 1, wherein the trench portion is formed at an entire part of the upper surface of the substrate.

4. The device of claim 1, wherein the trench portion has a section of a 'V' shape.

5. The device of claim 1, wherein the trench portion has a section of a'U'shape.

6. The device of claim 1, wherein the current spreading layer is formed of a transparent material.

7. The device of claim 1, wherein the current spreading layer is formed of a reflective opaque material.

8. A light emitting device comprising:
a substrate having a trench portion on an upper surface thereof;
a semiconductor layer formed on the substrate;
a p-electrode formed on an upper surface of a current spreading layer of the semiconductor layer; and
an n-electrode formed on an upper surface of an n-contact layer of the semiconductor layer.

9. The device of claim 8, wherein the trench portion has a section of a 'V' shape.

10. The device of claim 8, wherein the trench portion has a section of a 'U' shape.

11. The device of claim 8, wherein the current spreading layer is formed of a transparent material.

12. The device of claim 8, wherein the current spreading layer is formed of either Ni/Au or ITO.

13. The device of claim 8, wherein the current spreading layer is formed of a reflective opaque material.

14. The device of claim 8, wherein the substrate is formed of sapphire, gallium arsenide, silicon, silicon carbide, or gallium nitride.

15. A manufacturing method of a light emitting device comprising the steps of:
forming a trench portion on an upper surface of a substrate;
forming a buffer layer, an n-contact layer, an active layer, a p-contact layer, and a current spreading layer on the upper surface of the substrate where the trench portion is formed;
partially removing the active layer, the p-contact layer, and the current spreading layer by a mesa patterning processing so that the n-contact layer can be partially exposed;
forming a p-electrode on an upper surface of the current spreading layer so as to be electrically connected to the active layer and the p-contact layer; and
forming an n-electrode on an upper surface of the exposed n-contact layer so as to be electrically connected to the n-contact layer.

16. The method of claim 15, wherein the trench portion is formed at an entire part of the upper surface of the substrate.

17. The method of claim 15, wherein the trench portion is formed at a part of the upper surface of the substrate.

18. The method of claim 15, wherein the trench portion is formed on the upper surface of the substrate by a half cult dicing process.

19. The method of claim 15, wherein the trench portion has a section of a 'V' shape.

20. The method of claim 15, wherein the trench portion has a section of a 'U' shape.

21. The method of claim 15, wherein the buffer layer and the n-contact layer are formed by one of a metal organic chemical vapor deposition (MOCVD) method, a molecular beam epitaxy (MBE) method, and a liquid phase epitaxy (LPE) method.

22. The method of claim 15, wherein in the step of forming the trench portion, an etching mask is patterned on the upper surface of the substrate and then an etching process is performed.

23. The method of claim 22, wherein the etching process is performed by using one of an anisotropy dry etching method, a wet etching method, and an isotropy dry etching method.
